(19) Europäisches Patentamt
European Patent Office
Office européen des brevets

(11) **EP 4 554 353 A1**

(12) **DEMANDE DE BREVET EUROPEEN**

(43) Date de publication:
**14.05.2025 Bulletin 2025/20**

(21) Numéro de dépôt: **24209276.5**

(22) Date de dépôt: **28.10.2024**

(51) Classification Internationale des Brevets (IPC):
**H10D 48/01** (2025.01)  **H10D 48/00** (2025.01)
**H10D 64/27** (2025.01)  **H10D 62/10** (2025.01)
**B82Y 10/00** (2011.01)

(52) Classification Coopérative des Brevets (CPC):
**H10D 62/121; H10D 48/031; H10D 48/3835;**
**H10D 64/27;** B82Y 10/00; H10D 48/385

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **07.11.2023 FR 2312056**

(71) Demandeur: **Commissariat à l'Energie Atomique et aux Energies Alternatives**
**75015 Paris (FR)**

(72) Inventeurs:
- **MARTINEZ I DIAZ, Biel**
  **38054 GRENOBLE CEDEX 09 (FR)**
- **LI, Jing**
  **38054 GRENOBLE CEDEX 09 (FR)**

(74) Mandataire: **Cabinet Beaumont**
**4, Place Robert Schuman**
**B.P. 1529**
**38025 Grenoble Cedex 1 (FR)**

(54) **DISPOSITIF ÉLECTRONIQUE SPIN QUBIT COMPRENANT DES BOÎTES QUANTIQUES FORMÉES DANS UN NANOFIL PAR DES GRILLES**

(57)    La présente description concerne un dispositif électronique (100) comprenant :
- un nanofil de semi-conducteur (104) ;
- au moins deux premières grilles de commande (106) disjointes, disposées l'une à côté de l'autre du côté sur une première face latérale (108) du nanofil, et configurées pour commander chacune le potentiel électrostatique d'une boîte quantique (114) destinée à être formée dans le nanofil ;
- au moins une deuxième grille de commande (116) disposée du côté d'une deuxième face latérale (118),

opposée à la première face latérale, du nanofil, et configurée pour commander le potentiel électrostatique d'une région de couplage destinée à être formée entre deux boîtes quantiques ;
dans lequel toutes les premières grilles de commande sont disposées uniquement du côté de la première face latérale, et la ou toutes les deuxièmes grilles de commande sont disposées uniquement du côté de la deuxième face latérale;
et dans lequel aucune partie de la deuxième grille (116) n'est disposée entre les premières grilles (106).

Fig 1

**Description**

Domaine technique

La présente description concerne de façon générale le domaine de la spintronique, des dispositifs quantiques et de l'informatique quantique.

Technique antérieure

Il existe des dispositifs quantiques comportant des qubits basés sur la formation de boîtes quantiques assurant le confinement de charges élémentaires (électrons ou trous). L'information quantique est, par exemple, codée sur le spin de ces particules. Les boîtes quantiques sont formées par des grilles via lesquelles des potentiels de confinement électriques sont créés. Ces grilles permettent un ajustement local du potentiel électrostatique des boîtes quantiques, c'est-à-dire la profondeur des puits de potentiel des boîtes quantiques. Il est également nécessaire de pouvoir contrôler électriquement le couplage tunnel, c'est-à-dire la hauteur des barrières tunnel, entre les boîtes quantiques voisines.

Selon une première configuration, des grilles commandant le couplage entre les boîtes quantiques voisines et des grilles commandant les potentiels des boîtes quantiques peuvent être réalisées dans un même niveau de grille, les unes à côté des autres. Cette première configuration est par exemple décrite dans le document Ensar Vahapoglu et al., « Single-electron spin résonance in a nanoelectronic device using a global field » Sci. Adv., vol. 7 Issue 33, 13 août 2021, eabg9158.

Un problème rencontré avec cette première configuration est que la présence de toutes ces grilles de commande dans un même niveau nécessite d'avoir, pour les grilles contrôlant les potentiels dans les boîtes quantiques, un pitch, c'est-à-dire un espace entre les grilles contrôlant les potentiels de deux boîtes quantiques voisines, relativement important afin d'avoir la place nécessaire à la réalisation des grilles commandant le couplage entre les boîtes quantiques voisines.

Selon une deuxième configuration, les grilles commandant le couplage entre des boîtes quantiques voisines peuvent être réalisées dans un niveau de grilles différent de celui des grilles commandant les potentiels des boîtes quantiques. Cette deuxième configuration est par exemple décrite dans le document de T. Bédécarrats et al., "A new FDSOI spin qubit platform with 40nm effective control pitch," 2021 IEEE International Electron Devices Meeting (IEDM), San Francisco, CA, USA, 2021, pp. 1-4.

Un problème rencontré avec cette deuxième configuration est que la distance plus importante (par exemple de quelques dizaines de nanomètres) entre le niveau des grilles commandant le couplage entre les boîtes quantiques voisines et le semi-conducteur dans lequel les boîtes quantiques sont réalisées engendre un moins bon contrôle électrostatique de ces grilles.

Résumé de l'invention

Il existe donc un besoin de proposer un dispositif électronique ne présentant pas un ou plusieurs des inconvénients précédemment décrits.

Un mode de réalisation propose une solution à tout ou partie des inconvénients des solutions connues et porte sur un dispositif électronique comprenant :

- un nanofil de semi-conducteur ;

- au moins deux premières grilles de commande disjointes, disposées l'une à côté de l'autre du côté d'une première face latérale du nanofil de semi-conducteur, et configurées pour commander chacune le potentiel électrostatique d'une boîte quantique destinée à être formée dans le nanofil de semi-conducteur ;

- au moins une deuxième grille de commande disposée du côté d'une deuxième face latérale, opposée à la première face latérale, du nanofil de semi-conducteur, et configurée pour commander le potentiel électrostatique d'une région de couplage destinée à être formée entre deux boîtes quantiques ;

dans lequel toutes les premières grilles de commande du dispositif électronique sont disposées uniquement du côté de la première face latérale, et la ou toutes les deuxièmes grilles de commande du dispositif électronique sont disposées uniquement du côté de la deuxième face latérale.

Selon un mode de réalisation particulier, au moins une partie d'une projection orthogonale de la deuxième grille de commande dans un plan parallèle à la première face latérale du nanofil de semi-conducteur est disposée entre des projections orthogonales des deux premières grilles de commande dans le plan parallèle à la première face latérale du nanofil de semi-conducteur.

Selon un mode de réalisation particulier, aucune partie de la deuxième grille n'est disposée entre les premières grilles.

Selon un mode de réalisation particulier, chacune des premières grilles de commande recouvre une partie de la première face latérale du nanofil de semi-conducteur et/ou la deuxième grille de commande recouvre une partie de la deuxième face latérale du nanofil de semi-conducteur.

Selon un mode de réalisation particulier, chacune des premières grilles de commande recouvre une partie d'une face supérieure du nanofil de semi-conducteur qui est perpendiculaire aux première et deuxièmes faces latérales, et/ou la deuxième grille de commande recouvre une partie de la face supérieure du nanofil de semi-conducteur.

Selon un mode de réalisation particulier, les parties de la face supérieure recouvertes par les premières grilles de commande s'étendent depuis une première arête supérieure du nanofil de semi-conducteur formée à la jonction de la première face latérale et de la face supérieure, jusqu'à environ une moitié de la distance séparant les première et deuxième faces latérales l'une de l'autre.

Selon un mode de réalisation particulier, les parties de la face supérieure recouvertes par les premières grilles de commande s'étendent depuis une première arête supérieure du nanofil de semi-conducteur formée à la jonction de la première face latérale et de la face supérieure jusqu'à une deuxième arête supérieure du nanofil de semi-conducteur formée à la jonction de la deuxième face latérale et de la face supérieure.

Selon un mode de réalisation particulier, la partie de la face supérieure recouverte par la deuxième grille de commande s'étend depuis une deuxième arête supérieure du nanofil de semi-conducteur formée à la jonction de la deuxième face latérale et de la face supérieure jusqu'à environ une moitié de la distance séparant les première et deuxième faces latérales l'une de l'autre.

Selon un mode de réalisation particulier, le dispositif électronique comporte en outre une portion diélectrique traversant le nanofil de semi-conducteur depuis la face supérieure du nanofil de semi-conducteur jusqu'à une face inférieure du nanofil de semi-conducteur opposée à la face supérieure et disposée :

- entre les parties de la face supérieure du nanofil de semi-conducteur recouvertes par les premières grilles de commande et la partie de la face supérieure du nanofil de semi-conducteur recouverte par la deuxième grille de commande, ou

- entre une partie de la face supérieure du nanofil de semi-conducteur disposée entre les parties de la face supérieure du nanofil de semi-conducteur recouvertes par les premières grilles de commande et la partie de la face supérieure du nanofil de semi-conducteur recouverte par la deuxième grille de commande.

Selon un mode de réalisation particulier :

- une face supérieure de la deuxième grille de commande, parallèle à la face supérieure du nanofil de semi-conducteur, est disposée dans un même premier plan qu'une face supérieure de chacune des premières grilles de commande, ou

- la face supérieure de chacune des premières grilles de commande est disposée dans un premier plan se trouvant entre un deuxième plan dans lequel est disposée la face supérieure de la deuxième grille de commande et un troisième plan dans lequel est disposée une face supérieure du nanofil de semi-conducteur qui est perpendiculaire aux première et deuxièmes faces latérales.

Selon un mode de réalisation particulier, ladite au moins une deuxième grille de commande présente une dimension, mesurée selon une direction d'extension du nanofil de semi-conducteur (direction parallèle aux première et deuxième faces latérales du nanofil, et qui correspond à la longueur du nanofil), inférieure à une somme de la dimension de chacune des deux premières grilles de commande également mesurée selon la direction d'extension du nanofil de semi-conducteur.

Selon un mode de réalisation particulier, le dispositif électronique comprend N premières grilles de commande et N+1 deuxièmes grilles de commande, avec N nombre entier supérieur ou égal à 2.

Selon un mode de réalisation particulier, une distance entre ladite au moins une deuxième grille de commande et le nanofil de semi-conducteur est inférieure à 20 nm, et de préférence inférieure à 10 nm.

Selon un mode de réalisation particulier, l'au moins une deuxième grille est située à une distance (positive) de moins de 20nm du nanofil et de préférence à moins de 10nm du nanofil.

Selon un autre mode de réalisation, il est proposé un procédé de réalisation d'un dispositif électronique, comportant :

- réalisation d'au moins deux premières grilles de commande disjointes, disposées l'une à côté de l'autre du côté d'une première face latérale d'un nanofil de semi-conducteur, et configurées pour commander chacune le potentiel électrostatique d'au moins une boîte quantique destinée à être formée dans le nanofil de semi-conducteur ;

- réalisation d'au moins une deuxième grille de commande disposée du côté d'une deuxième face latérale, opposée à la première face latérale, du nanofil de semi-conducteur, et configurée pour commander le potentiel électrostatique d'une région de couplage destinée à être formée entre deux boîtes quantiques ;

et dans lequel toutes les premières grilles de commande du dispositif électronique sont disposées uniquement du côté de la première face latérale, et la ou toutes les deuxièmes grilles de commande du dispositif électronique sont disposées uniquement du côté de la deuxième face latérale.

Selon un mode de réalisation particulier, les premières et deuxième grilles de commande sont réalisées par la mise en oeuvre :

- d'au moins un dépôt de type « lift off » d'au moins un matériau électriquement conducteur, ou

- d'au moins un dépôt d'au moins une couche de matériau électriquement conducteur sur un substrat incluant le nanofil de semi-conducteur, puis au moins une gravure de la couche de matériau électriquement conducteur réalisée à travers des ouvertures ménagées dans un masque.

Selon un mode de réalisation particulier, le procédé comporte en outre, après le dépôt de type « lift off » du matériau électriquement conducteur ou après la gravure de la couche de matériau électriquement conducteur, la mise en oeuvre d'une gravure supplémentaire de portions restantes du matériau électriquement conducteur ou de la couche de matériau électriquement conducteur, achevant la réalisation des premières et deuxième grilles de commande.

Selon un mode de réalisation particulier, la réalisation des premières et deuxième grilles de commande est mise en oeuvre telle qu'au moins une partie d'une projection orthogonale de la deuxième grille de commande dans un plan parallèle à la première face latérale du nanofil de semi-conducteur soit disposée entre des projections orthogonales des deux premières grilles de commande dans le plan parallèle à la première face latérale du nanofil de semi-conducteur.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

- la figure 1 et la figure 2 représentent un premier exemple d'un dispositif électronique selon un mode de réalisation particulier ;

- la figure 3 représente une configuration particulière du premier exemple de dispositif électronique selon un mode de réalisation particulier ;

- la figure 4 et la figure 5 représentent un deuxième exemple d'un dispositif électronique selon un mode de réalisation particulier ;

- la figure 6 représente une configuration particulière du deuxième exemple de dispositif électronique selon un mode de réalisation particulier ;

- la figure 7 représente un troisième exemple d'un dispositif électronique selon un mode de réalisation particulier ;

- la figure 8 représente un quatrième exemple d'un dispositif électronique selon un mode de réalisation particulier ;

- la figure 9 représente un cinquième exemple d'un dispositif électronique selon un mode de réalisation particulier ;

- la figure 10 représente des simulations du contrôle du couplage tunnel entre deux boîtes quantiques obtenu dans un dispositif électronique selon un mode de réalisation particulier ;

- la figure 11, la figure 12 et la figure 13 représentent les étapes d'un premier exemple de procédé de réalisation d'un dispositif électronique selon un mode de réalisation particulier ;

- la figure 14 représente une des étapes d'un deuxième exemple de procédé de réalisation d'un dispositif électronique selon un mode de réalisation particulier ;

- la figure 15 représente un sixième exemple d'un dispositif électronique selon un mode de réalisation particulier ;

- la figure 16 représente un septième exemple d'un dispositif électronique selon un mode de réalisation particulier.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", "latéral", etc., ou à des qualificatifs d'orientation, tels que les termes "horizontal", "vertical", etc., il est fait référence sauf précision contraire à l'orientation des figures. Toutefois, ces termes ne présument pas de la position et de l'orientation réelles du dispositif lors de son utilisation.

Sauf précision contraire, les expressions "environ", "approximativement", "sensiblement", et "de l'ordre de" signifient à 10 % près, de préférence à 5 % près.

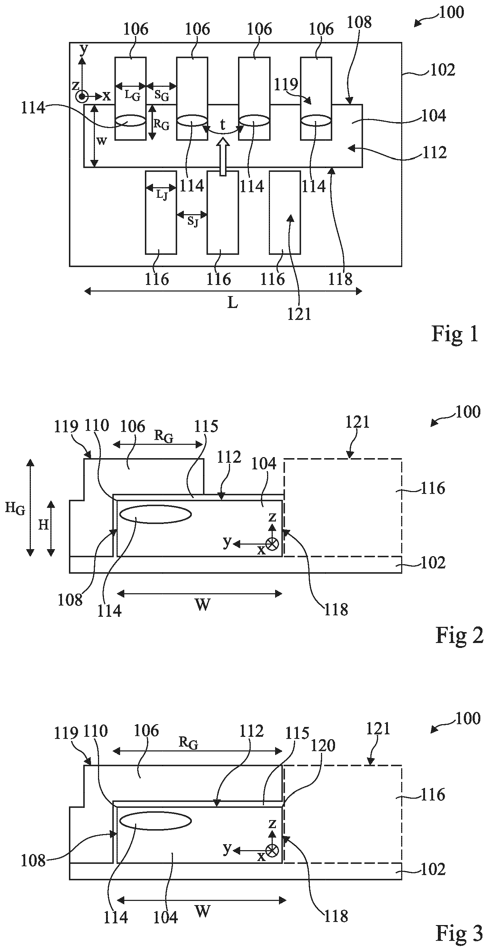

Un premier exemple d'un dispositif électronique 100 selon un mode de réalisation particulier est décrit ci-dessous en lien avec les figures 1 et 2. La figure 1 est une vue de dessus du dispositif 100 et la figure 2 est une vue en coupe latérale du dispositif 100.

Dans ce premier exemple ainsi que dans les exemples de réalisation suivants, le dispositif 100 comporte au moins une couche support 102 sur laquelle est disposé un nanofil de semi-conducteur 104. Selon une réalisation particulière du dispositif 100, le nanofil 104 peut correspondre à une portion restante d'une couche superficielle de semi-conducteur d'un substrat de type semi-conducteur sur isolant, par exemple SOI (« Silicon On Insulator », ou silicium sur isolant) . La couche support 102, dans ce cas, peut correspondre à l'empilement comprenant la couche diélectrique enterrée disposée sur la couche massive de semi-conducteur du substrat de type semi-conducteur sur isolant. La couche diélectrique enterrée correspond par exemple à une couche de $SiO_2$ et la couche massive comporte par exemple du silicium.

Par exemple, le nanofil 104 peut comporter du silicium lorsque les qubits destinés à être utilisés dans le dispositif 100 correspondent à des qubits d'électrons ou de trous. En variante, le nanofil 104 peut comporter par exemple du germanium lorsque les qubits destinés à être utilisés dans le dispositif 100 correspondent à des qubits de trous.

Dans ce premier exemple ainsi que dans les exemples de réalisation suivants, une largeur W du nanofil 104 (dimension parallèle à l'axe Y visible sur les figures 1 et 2) est par exemple comprise entre 15 nm et 120 nm, ou entre 30 nm et 120 nm. Une épaisseur H du nanofil 104 (dimension parallèle à l'axe Z visible sur les figures 1 et 2) est par exemple comprise entre 5 nm et 20 nm. Enfin, une longueur L du nanofil 104 (dimension parallèle à l'axe X visible sur les figures 1 et 2) est fonction du nombre de boîtes quantiques destinées à être formées dans le nanofil 104, et est par exemple comprise entre 30 nm et 100 nm par qubit.

Dans ce premier exemple ainsi que dans certains des exemples de réalisation suivants, le dispositif 100 comporte au moins deux premières grilles de commande 106 disjointes, disposées l'une à côté de l'autre, recouvrant chacune une partie d'une première face latérale 108 du nanofil 104 (face parallèle au plan (X,Z) sur les figures 1 et 2), d'une face supérieure 112 du nanofil 104 (face parallèle au plan (X,Y) sur les figures 1 et 2) et d'une première arête supérieure 110 du nanofil 104 formée à la jonction de la première face latérale 108 et de la face supérieure 112. Les premières grilles 106 sont ici configurées pour commander chacune le potentiel électrostatique d'une des boîtes quantiques 114 destinées à être formées dans le nanofil 104. Chacune des premières grilles 106 comporte au moins une portion électriquement conductrice. Une partie de chaque première grille 106 repose sur la couche support 102 et une autre partie de chaque première grille 106 repose sur une partie d'une couche diélectrique 115 se trouvant sur le nanofil 104.

Dans ce premier exemple ainsi que dans les exemples de réalisation suivants, le dispositif 100 comporte quatre premières grilles 106. En variante, le dispositif 100 peut toutefois comporter un nombre différent de premières grilles 106, ce nombre étant fonction du nombre de boîtes quantiques 114 destinées à être formées dans le nanofil 104.

Dans une configuration particulière applicable aux différents exemples de réalisation du dispositif 100 décrits, chacune des premières grilles 106 peut comporter au moins un matériau électriquement conducteur tel que du polysilicium, ou un empilement de plusieurs matériaux tel qu'un empilement de TiN, de polysilicium et de siliciure.

Sur les figures 1 et 2, les boîtes quantiques 114 destinées à être formées dans le nanofil 104 sont symboliquement représentées. Ces boîtes quantiques 114 sont destinées à être formées dans des parties du nanofil 104 soumises au contrôle électrostatique des premières grilles 106, ce contrôle électrostatique étant obtenu via le potentiel électrique appliqué sur chacune de ces premières grilles 106.

Dans une configuration particulière applicable aux différents exemples de réalisation du dispositif 100, chacune des premières grilles 106 comporte une longueur $L_G$ (dimension parallèle à la longueur L du nanofil 104) par exemple comprise entre 20 nm et 60 nm, et une hauteur $H_G$ (dimension parallèle à la hauteur H du nanofil 104) par exemple comprise entre 20 nm et 60 nm. La hauteur $H_G$ des premières grilles 106 est fonction notamment du ou des matériaux utilisés pour former ces premières grilles 106. En outre, deux premières grilles 106 voisines sont espacées l'une de l'autre d'une distance $S_G$ (parallèle à la longueur $L_G$ de chacune des premières grilles 106) par exemple comprise entre 20 nm et 100 nm. Enfin, la partie de chacune des premières grilles 106 disposée sur la face supérieure 112 du nanofil 104 s'étend sur une dimension $R_G$, perpendiculairement à la longueur $L_G$, par exemple comprise entre 0,2*W et W.

Dans une configuration particulière pouvant correspondre à celle représentée sur les figures 1 et 2, les parties de la face supérieure 112 recouvertes par les premières grilles 106 peuvent s'étendre depuis la première arête supérieure 110 jusqu'à une moitié de la distance séparant les première et deuxième faces latérales 108, 118 l'une de l'autre. Autrement dit, dans cette configuration particulière, $R_G = W/2$.

Dans le premier exemple ainsi que dans les exemples de réalisation suivants du dispositif 100, le nanofil 104 est recouverte d'une couche diélectrique 115 destinée à servir notamment d'oxyde de grille pour les premières grilles 106. La couche diélectrique 115 comporte par exemple du $SiO_2$ et/ou de l'$Al_2O_3$. L'épaisseur de la couche diélectrique 115 est par exemple comprise entre 2 nm et 20 nm. Sur la figure 1, la couche diélectrique 115 n'est pas représentée pour que le nanofil 104 soit visible.

Dans ce premier exemple ainsi que dans les exemples de réalisation suivants, le dispositif 100 comporte au moins une deuxième grille de commande 116 recouvrant une partie d'une deuxième face latérale 118, opposée à la première face latérale 108, du nanofil 104, et configurée pour commander le potentiel électrostatique d'une région de couplage destinée à être formée entre deux boîtes quantiques 114. Sur l'exemple de la figure 1, le contrôle du potentiel électrostatique d'une région de couplage destinée à être formée entre deux boîtes quantiques 114, par l'une des deuxièmes grilles 116, est symboliquement représenté par une flèche.

Dans la suite de la description, il est fait référence à plusieurs deuxièmes grilles de commande 116 du dispositif 100. Néanmoins, les différentes caractéristiques décrites en lien avec les deuxièmes grilles de commande 116 s'appliqueraient aussi à la seule deuxième grille de commande 116 du dispositif 100 si le dispositif 100 ne comportait qu'une seule deuxième grille de commande 116.

Dans ce premier exemple ainsi que dans les exemples de réalisation suivants, le dispositif 100 comporte trois deuxièmes grilles 116. En variante, le dispositif 100 peut comporter un nombre différent de deuxièmes grilles 116, ce nombre étant fonction du nombre de régions de couplage entre boîtes quantiques 114 à contrôler.

Dans une configuration particulière applicable aux différents exemples de réalisation du dispositif 100, chacune des deuxièmes grilles 116 comporte une longueur $L_J$ (dimension parallèle à la longueur L du nanofil 104) par exemple comprise entre 20 nm et 60 nm et une hauteur $H_J$ (dimension parallèle à la hauteur H du nanofil 104) par exemple comprise entre 20 nm et 100 nm. En outre, deux deuxièmes grilles 116 voisines sont espacées l'une de l'autre d'une distance $S_J$ (parallèle à la longueur $L_J$ de chacune des deuxièmes grilles 116) par exemple comprise entre 10 nm et 80 nm.

Dans le premier exemple de réalisation, chacune des deuxièmes grilles 116 comporte une hauteur $H_J$ égale à la hauteur $H_G$ des premières grilles 106. Ainsi, une face supérieure 119 de chacune des premières grilles 106, parallèle à la face supérieure 112 du nanofil 104, est disposée dans un même plan qu'une face supérieure 121 de chacune des deuxièmes grilles 116, également parallèle à la face supérieure 112 du nanofil 104.

Dans le premier exemple de réalisation, les deuxièmes grilles 116 ne recouvrent pas des parties de la face supérieure 112 du nanofil 104. En outre, dans l'exemple décrit, la couche diélectrique 115 forme également l'oxyde de grille pour les deuxièmes grilles 116.

Dans ce premier exemple de réalisation, pour chacune des deuxièmes grilles 116, au moins une partie d'une projection orthogonale, sur la première face latérale 108, de la partie de la deuxième face latérale 118 recouverte par la deuxième grille 116 est disposée entre les parties de la première face latérale 108 recouvertes par deux premières grilles 106 voisines. Dans une configuration particulière telle que représentée sur les figures 1 et 2, les bords de la deuxième grille 116 peuvent être alignés avec ceux des deux premières grilles 106, ce qui signifie qu'il n'y a pas de recouvrement entre la projection orthogonale, sur la première face latérale 108, de la partie de la deuxième face latérale 118 recouverte par chacune des deuxièmes grilles 116 et les parties de la première face latérale 108 recouvertes par les deux premières grilles 106 disposées de part et d'autre de cette deuxième grille 116. En variante, il est possible d'avoir un tel recouvrement partiel, par exemple tel qu'au maximum, la moitié de la surface de la projection orthogonale, sur la première face latérale 108, de la partie de la deuxième face latérale 118 recouverte par chacune des deuxièmes grilles 116 recouvre les parties de la première face latérale 108 recouvertes par les deux premières grilles 106 disposées de part et d'autre de cette deuxième grille 116.

Une configuration particulière du dispositif électronique 100 selon le premier exemple est décrite ci-dessous en lien avec la figure 3 qui est une vue en coupe latérale du dispositif 100.

Le dispositif 100 selon cette configuration particulière comporte tous les éléments du dispositif 100 selon le premier exemple précédemment décrit.

Toutefois, dans cette configuration particulière, les parties de la face supérieure 112 recouvertes par les premières grilles 106 s'étendent depuis la première arête supérieure 110 jusqu'à une deuxième arête supérieure 120 du nanofil 104 formée à la jonction de la deuxième face latérale 118 et de la face supérieure 112. Ainsi, dans cette configuration particulière, $R_G = W$.

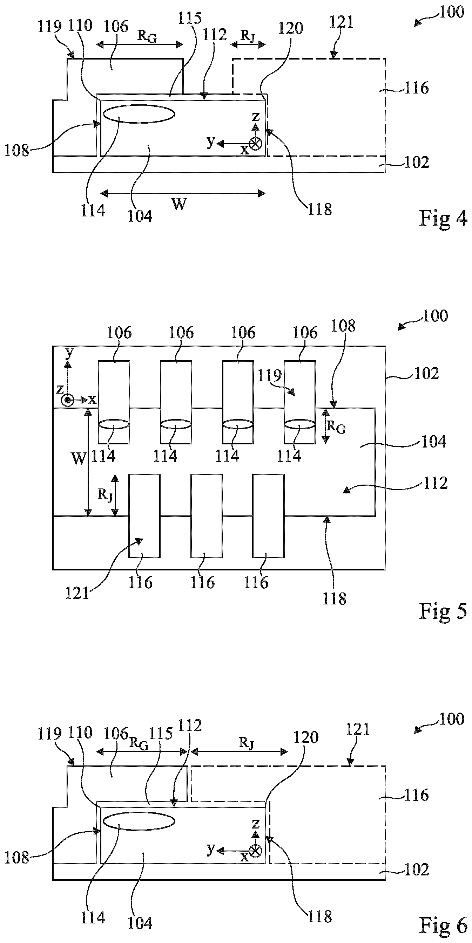

Un deuxième exemple d'un dispositif électronique 100 selon un mode de réalisation particulier est décrit ci-dessous en lien avec les figures 4 et 5. La figure 4 est une vue en coupe latérale du dispositif 100 et la figure 5 est une vue de dessus du dispositif 100.

Le dispositif 100 selon ce deuxième exemple comporte tous les éléments du dispositif 100 selon le premier exemple précédemment décrit.

Toutefois, dans ce deuxième exemple, chacune des deuxièmes grilles de commande 116 recouvre en outre une partie de la deuxième arête supérieure 120 du nanofil 104, et une partie de la face supérieure 112 du nanofil 104.

Dans ce deuxième exemple, la partie de chacune des deuxièmes grilles 116 disposée sur la face supérieure 112 du nanofil 104 peut s'étendre sur une dimension $R_J$, perpendiculaire à la longueur $L_J$, par exemple comprise entre 0 et W/2, ou plus généralement telle que $R_G + R_J < W$.

Dans une configuration particulière de ce deuxième exemple, les parties de la face supérieure 112 recouvertes par les deuxièmes grilles 116 peuvent s'étendre depuis la deuxième arête supérieure 120 jusqu'à une moitié de la distance séparant les première et deuxième faces latérales 108, 118 l'une de l'autre. Autrement dit, dans cette configuration particulière, $R_J = W/2$. Une telle configuration particulière est visible sur la figure 6.

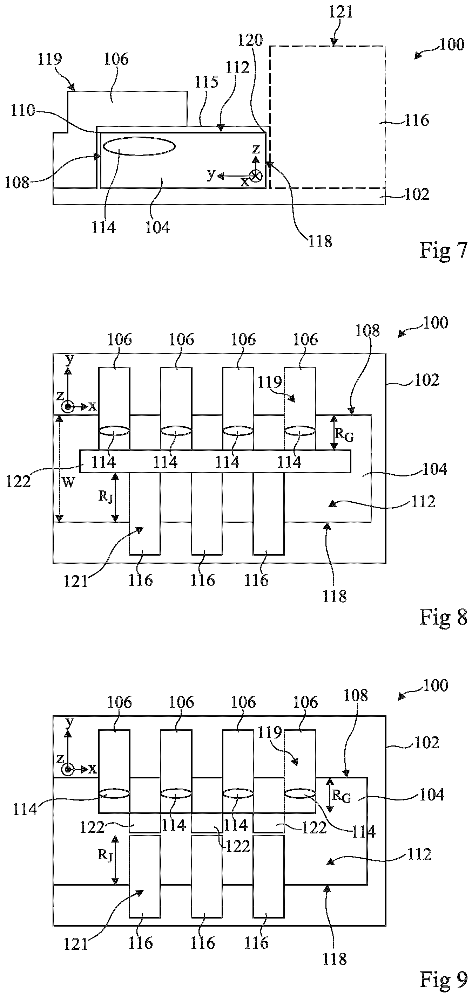

Un troisième exemple d'un dispositif électronique 100 selon un mode de réalisation particulier est décrit ci-dessous en lien avec la figure 7 correspondant à une vue en coupe latérale du dispositif 100.

Le dispositif 100 selon ce troisième exemple comporte tous les éléments du dispositif 100 selon les premier et deuxième exemples précédemment décrits. En outre, comme dans le premier exemple précédemment décrit, les deuxièmes grilles 116 ne recouvrent pas des parties de la face supérieure 112 du nanofil 104.

Par contre, contrairement aux précédents exemples dans lesquels chacune des deuxièmes grilles 116 comporte une hauteur $H_J$ égale à la hauteur $H_G$ des premières grilles 106, la hauteur $H_J$ de chacune des deuxièmes grilles 116 du dispositif 100 selon ce troisième exemple est supérieure à la hauteur $H_G$ des premières grilles 106. A titre d'exemple, la valeur du rapport $H_J/H_G$ peut être comprise par exemple entre 1 et 3. Dans ce troisième exemple, la face supérieure 119 de chacune des premières grilles 106 est disposée dans un premier plan se trouvant entre un deuxième plan dans lequel est disposée la face supérieure 121 de chacune des deuxièmes grilles 116 et un troisième plan dans lequel est disposée la face supérieure 112 du nanofil 104. Cette configuration dans laquelle la hauteur $H_J$ des deuxièmes grilles 116 est supérieure à la hauteur $H_G$ des premières grilles 106 améliore encore plus le contrôle électrostatique des régions de couplage entre les boîtes quantiques 114 par les deuxièmes grilles 116.

Cette caractéristique selon laquelle chacune des deuxièmes grilles 116 comporte une hauteur $H_J$ supérieure à la hauteur $H_G$ des premières grilles 106 peut s'appliquer aux exemples du dispositif 100 précédemment décrits. Autrement dit, il est possible d'avoir des deuxièmes grilles 116 de hauteur $H_J$ supérieure à la hauteur $H_G$ des premières grilles 106 et qui recouvrent également une partie de la face supérieure 112 du nanofil 104 (avec donc $R_J > 0$).

Un quatrième exemple d'un dispositif électronique 100 selon un mode de réalisation particulier est décrit ci-dessous en lien avec la figure 8 qui est une vue de dessus du dispositif 100.

Le dispositif 100 selon ce quatrième exemple comporte tous les éléments du dispositif 100 selon le troisième exemple précédemment décrit.

Le dispositif 100 selon ce quatrième exemple comporte en outre une portion diélectrique 122 traversant le nanofil 104 depuis la face supérieure 112 jusqu'à une face inférieure du nanofil 104 opposée à la face supérieure 112. L'épaisseur de la portion diélectrique 122 (dimension parallèle à l'axe Z) est donc ici au moins égale à l'épaisseur H du nanofil 104.

La portion diélectrique 122 est disposée entre les parties de la face supérieure 112 du nanofil 104 recouvertes par les premières grilles 106 et les parties de la face supérieure 112 du nanofil 104 recouvertes par les deuxièmes grilles 116.

La longueur de la portion 122 (dimension parallèle à la longueur L du nanofil 104) est par exemple telle que chacune des première grilles 106 soit disposée en face de la portion 122. La largeur de la portion 122 (dimension parallèle à la largeur W du nanofil 104) est par exemple égale à $W - R_G - R_J$ comme c'est le cas sur la figure 8. En variante, il est possible que la largeur de la portion 122 soit inférieure à $W - R_G - R_J$.

Dans ce quatrième exemple, il est possible que chacune des deuxièmes grilles 116 ait une hauteur $H_J$ supérieure ou égale à la hauteur $H_G$ des premières grilles 106.

Un cinquième exemple d'un dispositif électronique 100 selon un mode de réalisation particulier est décrit ci-dessous en lien avec la figure 9 qui est une vue de dessus du dispositif 100.

Le dispositif 100 selon ce cinquième exemple comporte tous les éléments du dispositif 100 selon le quatrième exemple précédemment décrit. Toutefois, par rapport au dispositif 100 selon le quatrième exemple précédemment décrit, le dispositif 100 selon ce cinquième exemple comporte plusieurs portions diélectriques 122 distinctes et disjointes les unes des autres. Chacune des portions diélectriques 122 traverse le nanofil 104 depuis la face supérieure 112 jusqu'à la face inférieure du nanofil 104. L'épaisseur de chacune des portions diélectriques 122 (dimension parallèle à l'axe Z) est donc ici égale à l'épaisseur H du nanofil 104.

Dans ce cinquième exemple, chacune des portions diélectriques 122 est disposée entre une partie de la face supérieure 112 du nanofil 104 disposée entre les parties de la face supérieure 112 du nanofil 104 recouvertes par les premières grilles 106 et la partie de la face supérieure 112 du nanofil 104 recouverte par l'une des deuxièmes grilles 116.

La longueur de chacune des portions 122 (dimension parallèle à la longueur L du nanofil 104) est par exemple supérieure ou égale à la longueur $L_G$ de chacune des deuxièmes grilles 116 (égale sur l'exemple de la figure 9). La largeur de chacune des portions 122 (dimension parallèle à la largeur W du nanofil 104) est par exemple égale à $W - R_G - R_J$. En variante, il est possible que la largeur de chacune des portions 122 soit inférieure à $W - R_G - R_J$.

Dans ce cinquième exemple, il est possible que chacune des deuxièmes grilles 116 ait une hauteur $H_J$ supérieure ou égale à la hauteur $H_G$ des premières grilles 106.

Dans les différents exemples de réalisation du dispositif 100, un potentiel électrique peut être appliqué sur les premières grilles 106 pour créer les boîtes quantiques 114 dans le nanofil 104. Les deuxièmes grilles 116 sont utilisées pour coupler ou découpler les qubits des boîtes quantiques 114 selon les besoins, en appliquant sur celles-ci des potentiels électriques adaptés.

Dans tous les exemples de réalisation du dispositif 100 précédemment décrits, le recouvrement des premières grilles 106 sur la face supérieure 112 du nanofil 104 limite fortement l'impact des deuxièmes grilles 116 sur les phénomènes électrostatiques se produisant dans les régions du nanofil 104 où les boîtes quantiques 114 sont formées.

Dans tous les exemples de réalisation du dispositif 100, les deuxièmes grilles 116 destinées à assurer le contrôle du couplage tunnel entre les boîtes quantiques 114 sont réalisées au même niveau, avec une hauteur $H_J$ supérieure ou égale à hauteur $H_G$ des premières grilles 106, que les premières grilles 106 destinées à assurer la formation des boîtes quantiques 114 dans le nanofil 104, et alignées en face des espaces se trouvant entre les premières grilles 106.

Dans les différents exemples de réalisation du dispositif 100 précédemment décrits, pour chacune des deuxièmes grilles 116, au moins une partie d'une projection orthogonale, sur la première face latérale 108, de la partie de la deuxième face latérale 118 recouverte par la deuxième grille 116 est disposée entre les parties de la première face latérale 108 recouvertes par deux premières grilles 106 voisines. Cette disposition des deuxièmes grilles 116 par rapport aux premières grilles 106 permet d'obtenir un fort contrôle électrostatique du couplage tunnel entre les boîtes quantiques 114, tout en évitant la formation de boîtes quantiques non souhaitées sous les deuxièmes grilles 116.

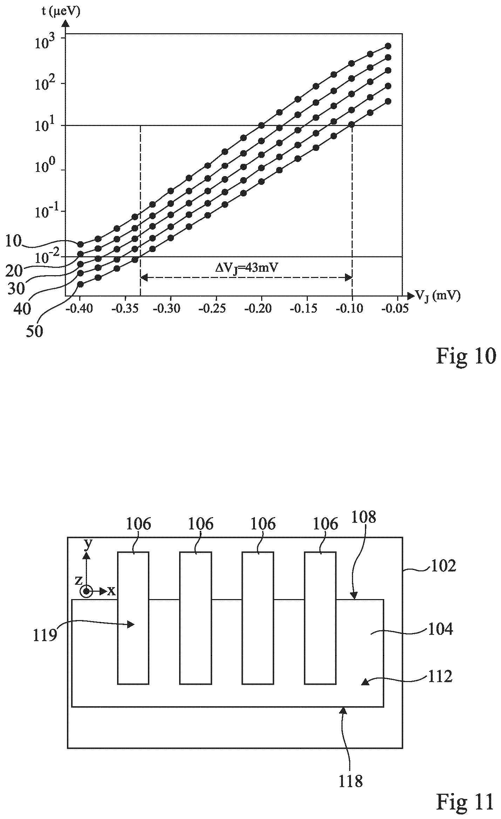

Les courbes visibles sur la figure 10 représentent la variation du couplage tunnel t, exprimé en peV, obtenue dans un dispositif 100 en faisant varier la tension $V_J$, exprimée en mV et correspondant à des impulsions de tension DC, appliquée sur les deuxièmes grilles 116 du dispositif 100, et pour différente valeurs de tension $V_G$, exprimée en mV, appliquée sur les premières grilles 106 du dispositif 100 formant les boîtes quantiques 114 dans lesquelles des électrons ou des trous sont piégés et dont le couplage tunnel est contrôlé. Les courbes référencées 10, 20, 30, 40 et 50 représentent respectivement le couplage tunnel t obtenu pour des valeurs de tension $V_G$ respectivement égales à 50 mV, 75 mV, 100 mV, 125 mV et 150 mV et pour une variation de $V_J$ entre -0,4 mV et -0,05 mV.

Ces simulations montrent que dans le dispositif 100, le couplage tunnel entre deux boîtes quantiques 114 peut passer d'un état ouvert ($t > 10^1$ peV) à un état fermé ($t < 10^{-2}$ peV), ou vice-versa, avec une variation de la tension $V_J$ appliquée sur les deuxièmes grilles 116 de l'ordre de 43 mV.

Le contrôle, appelé $\alpha$, du couplage tunnel t peut s'exprimer par l'équation :

[Math 1]

$$\alpha = \frac{\delta log^2(t)}{\delta V_J}$$

Avec le dispositif 100, le contrôle $\alpha$ du couplage tunnel t obtenu est de l'ordre de 900 $V^{-1}$. A titre de comparaison, le contrôle du couplage tunnel obtenu avec les dispositifs de l'art antérieur est généralement inférieur à environ 40 $V^{-1}$.

Dans les différents exemples précédemment décrits, les bords de chacune des deuxièmes grilles 116 sont alignés avec ceux de deux premières grilles 106 voisines, ce qui implique que $L_G = S_J$ et que $L_J = S_G$. En variante, il est possible d'avoir un recouvrement entre la projection orthogonale, sur la première face latérale 108, de la partie de la deuxième face latérale 118 recouverte par la deuxième grille 116 et les parties de la première face latérale 108 recouvertes par les deux premières grilles 106 voisines. Dans ce cas, les dimensions $L_G$, $S_G$, $L_J$ et $S_J$ sont telles que $L_J > S_G$ et $L_G > S_J$.

Dans tous les exemples de réalisation, il est possible d'avoir $L_G > S_G$ et $L_J > S_J$, ce qui permet de réduire le pitch de grilles atteignable avec le dispositif 100.

Dans tous les exemples de réalisation, il est également possible d'avoir des deuxièmes grilles 116 plus longues que les premières grilles 106, c'est-à-dire telles que $L_J > L_G$, ou moins longues que les premières grilles 106, c'est-à-dire telles que $L_J < L_G$. De mêmes, la dimension $S_G$ peut être supérieure ou inférieure ou égale à la dimension $S_J$.

Dans tous les exemples de réalisation, il est possible de dimensionner et positionner les premières et deuxièmes grilles 106, 116 telles que $L_G + S_G = L_J + S_J$.

Dans tous les exemples de réalisation, les premières et deuxièmes grilles 106, 116 peuvent être dimensionnées telles que $R_G + R_J < W$ afin d'éviter des problèmes de contacts électriques non désirés entre les premières et deuxièmes grilles 106, 116.

Le dispositif 100 peut comporter une structure de grilles 106, 116 compatible avec des processus de fabrication de l'industrie microélectronique et qui permet d'avoir un fort contrôle électrostatique sur le couplage tunnel entre les boites quantiques 114. Les première grilles 106 servant à la formation des boîtes quantiques 114 et les deuxièmes grilles 116 servant au contrôle du couplage tunnel entre les boîtes quantiques 114 sont disposées dans un même niveau de grilles, ce qui facilite leur réalisation.

Le dispositif 100 comporte au moins deux premières grilles 106, le nombre de premières grilles 106, et donc également de deuxièmes grilles 116, étant choisi selon le nombre de boîtes quantiques 114 à former et à contrôler dans le nanofil 104.

Un premier exemple d'un procédé de réalisation du dispositif électronique 100 est décrit ci-dessous en lien avec les figures 11 à 13.

Le nanofil 104 est tout d'abord réalisé, par exemple par gravure de la couche superficielle d'un substrat SOI. D'autres techniques peuvent être mises en oeuvre pour former le nanofil 104 sur la couche support 102.

La couche diélectrique 115 est ensuite réalisée de manière à recouvrir le nanofil 104. Par exemple, lorsque la couche diélectrique 115 comporte du $SiO_2$ et que le nanofil 104 comporte du silicium, la couche diélectrique 115 peut être réalisée par une oxydation thermique du silicium du nanofil 104.

Les premières grilles 106 sont ensuite réalisées, par exemple par un dépôt de type « lift-off » d'un ou plusieurs matériaux électriquement conducteurs. La structure obtenue à ce stade du procédé est représentée sur la figure 11.

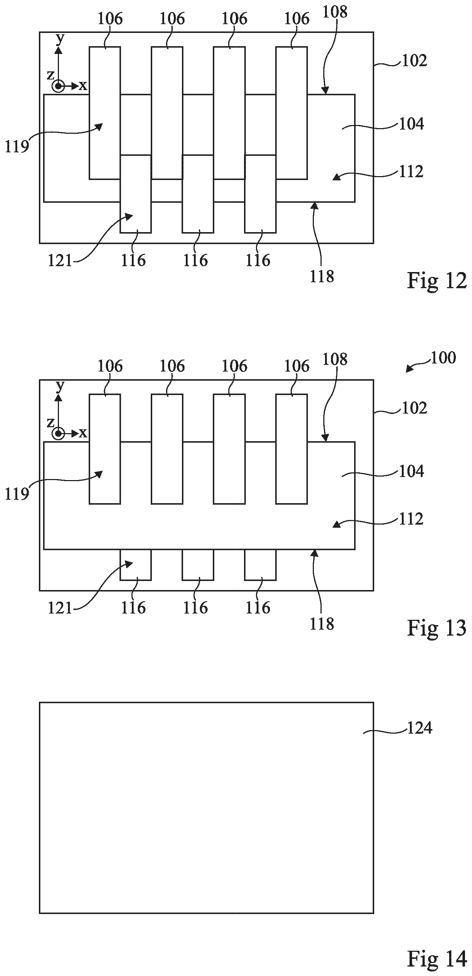

Les deuxièmes grilles 116 sont ensuite réalisées, par exemple par un dépôt de type « lift-off » d'un ou plusieurs matériaux électriquement conducteurs. La structure obtenue à ce stade du procédé est représentée sur la figure 12.

Une étape de gravure des premières et deuxièmes grilles 106, 116 est ensuite mise en oeuvre afin d'obtenir les dimensions souhaitées pour ces grilles 106, 116, notamment les dimensions $R_G$ et $R_J$ désirées. Le dispositif 100 ainsi obtenu est représenté sur la figure 13.

En variante du procédé décrit ci-dessus, il est possible que les premières et deuxièmes grilles 106, 116 soient réalisées en mettant en oeuvre une même étape de dépôt.

Un deuxième exemple de procédé de réalisation d'un dispositif électronique 100 est décrit ci-dessous.

Le nanofil 104 et la couche diélectrique 115 sont tout d'abord réalisés, par exemple comme précédemment décrit pour le premier exemple de procédé de réalisation du dispositif 100.

Une ou plusieurs couches 124 de matériau électriquement conducteur sont ensuite déposées sur l'ensemble de la structure réalisée, c'est-à-dire sur le nanofil 104 recouvert par la couche diélectrique 115 et sur les parties de la couche support 102 non recouvertes par le nanofil 104 et la couche diélectrique 115. La figure 14 représente une vue de dessus de la structure obtenue à ce stade du procédé.

La ou les couches 124 sont ensuite gravées en utilisant un masque dur, formant les premières grilles 106 et les deuxièmes grilles 116 soit au cours d'une même étape de gravure, soit au cours d'étapes de gravure distinctes. La structure obtenue à ce stade du procédé est similaire à celle représentée sur la figure 12.

Une étape de gravure des premières et deuxièmes grilles 106, 116 est ensuite mise en oeuvre afin d'obtenir les dimensions souhaitées pour ces grilles 106, 116, notamment les dimensions $R_G$ et $R_J$ désirées. Le dispositif 100 ainsi obtenu est similaire à celui représenté sur la figure 13.

En variante des procédés décrits ci-dessus, il est possible de réaliser les premières et deuxièmes grilles 106, 116 directement aux dimensions souhaitées, sans avoir à mettre en oeuvre l'étape de gravure finale décrite en lien avec la figure 13.

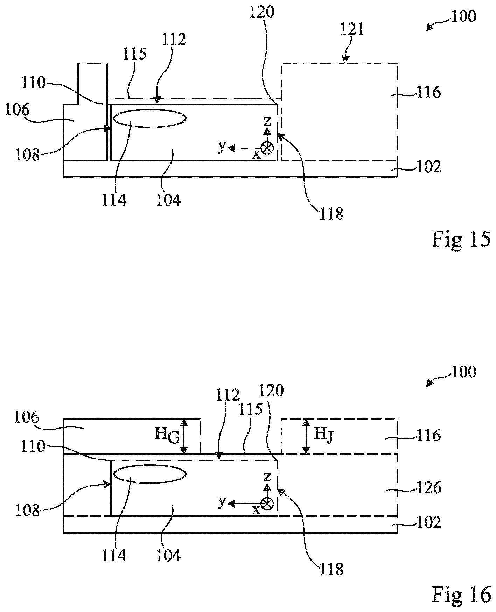

La figure 15 représente un cinquième exemple de réalisation du dispositif 100.

Dans ce cinquième exemple, contrairement aux précédents exemples de réalisation, ni les premières grilles 106 ni les deuxièmes grilles 116 ne recouvrent la face supérieure 112 du nanofil 104, ni les arêtes supérieures 110, 120 du nanofil 104. En outre, chacune des premières grilles 106 recouvre une partie de la première face latérale 108 du nanofil 104 et chacune des deuxièmes grilles 116 recouvre une partie de la deuxième face latérale 118 du nanofil 104. Dans ce cinquième exemple, la relation suivante est vérifiée : $R_G = R_J = 0$. Les autres caractéristiques et variantes précédemment décrites pour les précédents exemples de réalisation, comme par exemple le fait d'avoir des premières grilles 106 de hauteur différente de celle des deuxièmes grilles 116 ($H_J \neq H_G$) peuvent s'appliquer à ce cinquième exemple de réalisation.

La figure 16 représente un sixième exemple de réalisation du dispositif 100.

Dans ce sixième exemple, contrairement aux précédents exemples de réalisation, ni les premières grilles 106 ni les deuxièmes grilles 116 ne recouvrent des parties des première et deuxième faces latérales 108, 118 du nanofil 104. En outre, chacune des premières grilles 106 recouvre une partie de la face supérieure 112 du nanofil 104. Les deuxièmes grilles 116 ne recouvrent pas la face supérieure 112 du nanofil 104. Dans ce sixième exemple, la dimension $R_G$ est non nulle, et la dimension $R_J$ est nulle. En variante, il est possible que les deuxièmes grilles 116 recouvrent une partie de la face supérieure 112 du nanofil 104, et donc que $R_J > 0$, et/ou que les hauteurs $H_G$ et $H_J$ des premières et deuxièmes grilles 106, 116 soient différentes.

Dans ce sixième exemple, les premières et deuxièmes grilles 106, 116 ne reposent pas directement sur la couche support, mais sur au moins un matériau diélectrique 126 interposé entre la couche support 102 et les premières et deuxièmes grilles 106, 116. Le matériau diélectrique 126 peut par exemple servir à former également la couche diélectrique 115.

Dans ce sixième exemple, les premières et deuxièmes grilles 106, 116 forment des grilles planaires.

Dans tous les exemples de réalisation, les premières grilles de commande 106 sont disposées du côté de la première face latérale 108 du nanofil 104, et les deuxièmes grilles de commande 116 sont disposées du côté de la deuxième face latérale 118 du nanofil 104.

Dans les différents exemples de réalisation décrits, il est possible qu'aucune partie de la deuxième grille 116 n'est disposée, physiquement ou en projection par exemple dans un plan parallèle à la première face latérale 108, entre les deux premières grilles 106.

Dans les différents exemples de réalisation, au moins une partie d'une projection orthogonale de la ou de chacune des deuxièmes grilles de commande 116 dans un plan perpendiculaire à la face supérieure 112 du nanofil 104, ou dans un plan parallèle aux faces latérales 108, 118, peut être disposée entre des projections orthogonales de deux premières grilles de commande 106 dans le plan perpendiculaire à la face supérieure 112 ou dans le plan parallèle aux faces latérales 108, 118.

Dans les différents exemples de réalisation, les premières grilles de commande 106 peuvent être disposées dans un même plan que la ou les deuxièmes grilles de commande 116.

Dans les différents exemples de réalisation précédemment décrits excepté celui décrit en lien avec la figure 8, lorsque $R_J$ est non nul, c'est-à-dire lorsque les deuxièmes grilles 116 recouvrent des parties de la face supérieure 112 du nanofil 104, les deuxièmes grilles 116 peuvent être servir à réaliser, en plus du contrôle des régions de couplage entre les boîtes quantiques 114, une lecture de spin basée sur le blocage de Pauli (lecture de type Elzerman). Dans ce cas, la lecture de spin est réalisée grâce à des boîtes quantiques formées sous les deuxièmes grilles 116.

Afin d'éviter le déclenchement de transferts de charge non-désirés avec les qubits, et lorsque la dimension $R_J$ est non nulle, le dispositif 100 peut être réalisé de préférence tel qu'il comporte une ou plusieurs portions diélectriques 122 telles que précédemment décrit en lien avec les figures 8 et 9, car cette ou ces portions diélectriques 122 empêchent alors de tels transferts de charge. Les deuxièmes grilles 116 peuvent dans ce cas être utilisées comme détecteurs de charge grâce à des boîtes quantiques formées sous les deuxièmes grilles 116.

En variante d'une lecture des qubits par les deuxièmes grilles 116, la lecture des qubits des boîtes quantiques 100 peut être réalisée en utilisant des boîtes quantiques auxiliaires formées à proximité de faces latérales du nanofil 104 qui sont par exemple perpendiculaires aux faces latérales 108, 118. Par exemple, en considérant le dispositif 100 représenté sur la figure 1, ces boîtes quantiques auxiliaires peuvent correspondre à celles formées sous chacun des deux premières grilles 106 les plus proches des extrémités du nanofil 104.

En variante des différents exemples de réalisation précédemment décrits, le nanofil 104 peut ne pas correspondre à une portion restante d'une couche superficielle d'un substrat de type semi-conducteur sur isolant, et être formée, par exemple par dépôt ou toute autre technique adaptée, sur ou à partir d'un autre type de couche support 102 correspondant par exemple un substrat bulk ou massif tel qu'un wafer semi-conducteur.

En variante des différents exemples de réalisation précédemment décrits, les oxydes de grille disposés entre le nanofil 104 et les premières grilles 106 et/ou les deuxièmes grilles 116 peuvent être formés par des portions de matériau diélectrique différents de la couche diélectrique 115.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications données ci-dessus. Par exemple, la nature (humide, sèche, etc.) de chacune des gravures mises en oeuvre peut être choisie en fonction notamment du ou des matériaux à graver.

**Revendications**

1. Dispositif électronique (100) comprenant :

    - un nanofil de semi-conducteur (104) ;

**EP 4 554 353 A1**

- au moins deux premières grilles de commande (106) disjointes, disposées l'une à côté de l'autre du côté d'une première face latérale (108) du nanofil de semi-conducteur (104), et configurées pour commander chacune le potentiel électrostatique d'une boîte quantique (114) destinée à être formée dans le nanofil de semi-conducteur (104) ;

- au moins une deuxième grille de commande (116) disposée du côté d'une deuxième face latérale (118), opposée à la première face latérale (108), du nanofil de semi-conducteur (104), et configurée pour commander le potentiel électrostatique d'une région de couplage destinée à être formée entre deux boîtes quantiques (114) ;

dans lequel toutes les premières grilles de commande (106) du dispositif électronique (100) sont disposées uniquement du côté de la première face latérale (108), et la ou toutes les deuxièmes grilles de commande (116) du dispositif électronique (100) sont disposées uniquement du côté de la deuxième face latérale (118), et dans lequel aucune partie de la deuxième grille (116) n'est disposée entre les premières grilles (106).

2. Dispositif électronique (100) selon la revendication 1, dans lequel au moins une partie d'une projection orthogonale de la deuxième grille de commande (116) dans un plan parallèle à la première face latérale (108) du nanofil de semi-conducteur (104) est disposée entre des projections orthogonales des deux premières grilles de commande (106) dans le plan parallèle à la première face latérale (108) du nanofil de semi-conducteur (104).

3. Dispositif électronique (100) selon l'une quelconque des revendications précédentes, dans lequel chacune des premières grilles de commande (106) recouvre une partie de la première face latérale (108) du nanofil de semi-conducteur (104) et/ou dans lequel la deuxième grille de commande (116) recouvre une partie de la deuxième face latérale (118) du nanofil de semi-conducteur (104).

4. Dispositif électronique (100) selon l'une quelconque des revendications précédentes, dans lequel chacune des premières grilles de commande (106) recouvre une partie d'une face supérieure (112) du nanofil de semi-conducteur (104) qui est perpendiculaire aux première et deuxièmes faces latérales (108, 118), et/ou dans lequel la deuxième grille de commande (116) recouvre une partie de la face supérieure (112) du nanofil de semi-conducteur (104).

5. Dispositif électronique (100) selon la revendication 4, dans lequel les parties de la face supérieure (112) recouvertes par les premières grilles de commande (106) s'étendent depuis une première arête supérieure (110) du nanofil de semi-conducteur (104) formée à la jonction de la première face latérale (108) et de la face supérieure (112), jusqu'à environ une moitié de la distance séparant les première et deuxième faces latérales (108, 118) l'une de l'autre.

6. Dispositif électronique (100) selon la revendication 4, dans lequel les parties de la face supérieure (112) recouvertes par les premières grilles de commande (106) s'étendent depuis une première arête supérieure (110) du nanofil de semi-conducteur (104) formée à la jonction de la première face latérale (108) et de la face supérieure (112) jusqu'à une deuxième arête supérieure (120) du nanofil de semi-conducteur (104) formée à la jonction de la deuxième face latérale (118) et de la face supérieure (112).

7. Dispositif électronique (100) selon la revendication 4, comportant en outre une portion diélectrique (122) traversant le nanofil de semi-conducteur (104) depuis la face supérieure (112) du nanofil de semi-conducteur (104) jusqu'à une face inférieure du nanofil de semi-conducteur (104) opposée à la face supérieure (112) et disposée :

- entre les parties de la face supérieure (112) du nanofil de semi-conducteur (104) recouvertes par les premières grilles de commande (106) et la partie de la face supérieure (112) du nanofil de semi-conducteur (104) recouverte par la deuxième grille de commande (116), ou
- entre une partie de la face supérieure (112) du nanofil de semi-conducteur (104) disposée entre les parties de la face supérieure (112) du nanofil de semi-conducteur (104) recouvertes par les premières grilles de commande (106) et la partie de la face supérieure (112) du nanofil de semi-conducteur (104) recouverte par la deuxième grille de commande (116).

8. Dispositif électronique (100) selon l'une quelconque des revendications précédentes, dans lequel :

- une face supérieure (121) de la deuxième grille de commande (116), parallèle à la face supérieure (112) du nanofil de semi-conducteur (104), est disposée dans un même premier plan qu'une face supérieure (119) de chacune des premières grilles de commande (106), ou
- la face supérieure (119) de chacune des premières grilles de commande (106) est disposée dans un premier plan se trouvant entre un deuxième plan dans lequel est disposée la face supérieure (121) de la deuxième grille de commande (116) et un troisième plan dans lequel est disposée une face supérieure (112) du nanofil de semi-conducteur (104) qui est perpendiculaire aux première et deuxièmes faces latérales (108, 118).

9. Dispositif électronique (100) selon l'une des quelconque des revendications précédentes, dans lequel ladite au moins une deuxième grille de commande (116) présente une dimension, mesurée selon une direction d'extension du nanofil de semi-conducteur (114), inférieure à une somme des dimensions de chacune des deux premières grilles de commande (106) selon la direction d'extension du nanofil de semi-conducteur.

10. Dispositif électronique (100) selon l'une quelconque des revendications précédentes, comprenant N premières grilles de commande (106) et N+1 deuxièmes grilles de commande (116), avec N nombre entier supérieur ou égal à 2.

11. Dispositif électronique (100) selon l'une quelconque des revendications précédentes, dans lequel une distance entre ladite au moins une deuxième grille de commande (116) et le nanofil de semi-conducteur (114) est inférieure à 20 nm, et de préférence inférieure à 10 nm.

12. Procédé de réalisation d'un dispositif électronique (100), comportant :

- réalisation d'au moins deux premières grilles de commande (106) disjointes, disposées l'une à côté de l'autre du côté d'une première face latérale (108) d'un nanofil de semi-conducteur (104), et configurées pour commander chacune le potentiel électrostatique d'au moins une boîte quantique (114) destinée à être formée dans le nanofil de semi-conducteur (104) ;
- réalisation d'au moins une deuxième grille de commande (116) disposée du côté d'une deuxième face latérale (118), opposée à la première face latérale (108), du nanofil de semi-conducteur (104), et configurée pour commander le potentiel électrostatique d'une région de couplage destinée à être formée entre deux boîtes quantiques (114) ;
dans lequel toutes les premières grilles de commande (106) du dispositif électronique (100) sont disposées uniquement du côté de la première face latérale (108), et la ou toutes les deuxièmes grilles de commande (116) du dispositif électronique (100) sont disposées uniquement du côté de la deuxième face latérale (118), et dans lequel aucune partie de la deuxième grille (116) n'est disposée entre les premières grilles (106).

13. Procédé selon la revendication 12, dans lequel les premières et deuxième grilles de commande (106, 116) sont réalisées par la mise en oeuvre :

- d'au moins un dépôt de type « lift off » d'au moins un matériau électriquement conducteur, ou
- d'au moins un dépôt d'au moins une couche de matériau électriquement conducteur (124) sur un substrat incluant le nanofil de semi-conducteur (104), puis au moins une gravure de la couche de matériau électriquement conducteur (124) réalisée à travers des ouvertures ménagées dans un masque.

14. Procédé selon la revendication 13, comportant en outre, après le dépôt de type « lift off » du matériau électriquement conducteur ou après la gravure de la couche de matériau électriquement conducteur (124), la mise en oeuvre d'une gravure supplémentaire de portions restantes du matériau électriquement conducteur ou de la couche de matériau électriquement conducteur (124), achevant la réalisation des premières et deuxième grilles de commande (106, 116).

15. Procédé selon l'une des revendications 12 à 14, dans lequel la réalisation des premières et deuxième grilles de commande (106, 116) est mise en oeuvre telle qu'au moins une partie d'une projection orthogonale de la deuxième grille de commande (116) dans un plan parallèle à la première face latérale (108) du nanofil de semi-conducteur (104) soit disposée entre des projections orthogonales des deux premières grilles de commande (106) dans le plan parallèle à la première face latérale (108) du nanofil de semi-conducteur (104).

Fig 1

Fig 2

Fig 3

Fig 4

Fig 5

Fig 6

Fig 7

Fig 8

Fig 9

t (μeV)

$10^3$

$10^2$

$10^1$

$10^0$

$10^{-1}$

$10^{-2}$

10

20

30

40

50

$\Delta V_J = 43mV$

$V_J$ (mV)

-0.40  -0.35  -0.30  -0.25  -0.20  -0.15  -0.10  -0.05

Fig 10

106   106   106   106   108

y

z    x

119

102

104

112

118

Fig 11

16

Fig 12

Fig 13

Fig 14

Fig 15

Fig 16

Europäisches
Patentamt

European
Patent Office

Office européen
des brevets

**RAPPORT DE RECHERCHE EUROPEENNE**

Numéro de la demande

EP 24 20 9276

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | ANDREA CORNA ET AL: "Electrically driven electron spin resonance mediated by spin-valley-orbit coupling in a silicon quantum dot", ARXIV.ORG, CORNELL UNIVERSITY LIBRARY, 201 OLIN LIBRARY CORNELL UNIVERSITY ITHACA, NY 14853, 9 août 2017 (2017-08-09), XP081406239, DOI: 10.1038/S41534-018-0059-1 * Figure 1 et texte correspondant. * | 1-8, 10-15 | INV. H10D48/01 H10D48/00 H10D64/27 H10D62/10 ADD. B82Y10/00 |
| X | EP 3 967 650 A1 (IMEC VZW [BE]) 16 mars 2022 (2022-03-16) * Figures 1, 2A-2C et texte correspondant.; alinéas [0063] - [0065], [0089] * | 1,2,4, 6-15 | |
| X | EP 3 646 393 B1 (COMMISSARIAT ENERGIE ATOMIQUE [FR]) 16 juin 2021 (2021-06-16) * Figures 2, 4, 8 et texte correspondnant. * | 1-15 | |
| | | | DOMAINES TECHNIQUES RECHERCHES (IPC) |
| A | CN 115 312 602 A (INST SEMICONDUCTORS CAS) 8 novembre 2022 (2022-11-08) * Figures 1, 2 et texte correspondant. * | 1-15 | B82Y H10D |
| A | EP 3 082 073 A1 (HITACHI LTD [JP]) 19 octobre 2016 (2016-10-19) * Figures 1-3, 6, 11-13 et texte correspondant. * | 1-15 | |
| A | EP 3 701 567 B1 (COMMISSARIAT ENERGIE ATOMIQUE [FR]) 3 novembre 2021 (2021-11-03) * Figures 1-4 et texte correspondant. * | 1-15 | |

Le présent rapport a été établi pour toutes les revendications

| Lieu de la recherche | Date d'achèvement de la recherche | Examinateur |
|---|---|---|
| Munich | 4 mars 2025 | Dauw, Xavier |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**EP 4 554 353 A1**

## ANNEXE AU RAPPORT DE RECHERCHE EUROPEENNE
## RELATIF A LA DEMANDE DE BREVET EUROPEEN NO.

EP 24 20 9276

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

04-03-2025

| Document brevet cité au rapport de recherche | | Date de publication | Membre(s) de la famille de brevet(s) | | Date de publication |
|---|---|---|---|---|---|
| EP 3967650 | A1 | 16-03-2022 | CN | 114186296 A | 15-03-2022 |
| | | | EP | 3967650 A1 | 16-03-2022 |
| | | | US | 2022083890 A1 | 17-03-2022 |
| EP 3646393 | B1 | 16-06-2021 | EP | 3646393 A1 | 06-05-2020 |
| | | | FR | 3068518 A1 | 04-01-2019 |
| | | | FR | 3068519 A1 | 04-01-2019 |
| | | | US | 2020226486 A1 | 16-07-2020 |
| CN 115312602 | A | 08-11-2022 | AUCUN | | |
| EP 3082073 | A1 | 19-10-2016 | EP | 3082073 A1 | 19-10-2016 |
| | | | US | 2016300155 A1 | 13-10-2016 |
| EP 3701567 | B1 | 03-11-2021 | CN | 111386610 A | 07-07-2020 |
| | | | EP | 3701567 A1 | 02-09-2020 |
| | | | FR | 3073079 A1 | 03-05-2019 |
| | | | US | 2020343435 A1 | 29-10-2020 |
| | | | WO | 2019081837 A1 | 02-05-2019 |

EPO FORM P0460

Pour tout renseignement concernant cette annexe : voir Journal Officiel de l'Office européen des brevets, No.12/82

RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **ENSAR VAHAPOGLU et al.** Single-electron spin résonance in a nanoelectronic device using a global field. *Sci. Adv.*, 13 August 2021, vol. 7 (33), eabg9158

- **T. BÉDÉCARRATS et al.** A new FDSOI spin qubit platform with 40nm effective control pitch. *2021 IEEE International Electron Devices Meeting (IEDM), San Francisco, CA, USA*, 2021, 1-4